# EUROPÄISCHE PATENTANMELDUNG

(11) **EP 3 996 478 A1**
(43) Veröffentlichungstag der Anmeldung: **11.05.2022**
(21) Anmeldenummer: 21205269.0
(22) Anmeldetag: 28.10.2021
(51) Int. Cl.: H05K 7/14

(54) **SYSTEM ZUM SICHERHEITSGERICHTETEN ENTWÄRMEN EINES SCHALTSCHRANKS**

(30) Priorität: 04.11.2020 DE 102020129085
(71) Anmelder: PTC Rail OEM GmbH, 13507 Berlin (DE)
(72) Erfinder: Niedermüller, Bernd, 16356 Ahrensfelde (DE); Laske, Olaf, 12559 Berlin (DE); Glanck, Peter, 12621 Berlin (DE); Bernd, Frederick, 12435 Berlin (DE)
(74) Vertreter: Maikowski & Ninnemann Patentanwälte Partnerschaft mbB

(57) **Zusammenfassung**

Ein System mit einem offenen Schaltschrank, insbesondere für ein Schienenfahrzeug, umfasst ein Kühlsystem und eine Schaltungsanordnung zur sicherheitsgerichteten Steuerung des Kühlsystems, wobei die Schaltungsanordnung eine erste Detektionsvorrichtung zur Detektion eines Brands im Schaltschrank aufweist, wobei die Schaltungsanordnung eine Steuereinheit aufweist, wobei ein Ausgang der Steuereinheit mit dem Kühlsystem verbunden ist, wobei die Schaltungsanordnung einen ersten Erfassungspfad zur Signalisierung eines Fehlerfalls an die Steuereinheit aufweist, der einen Ausgang der ersten Detektionsvorrichtung mit einem ersten Eingang der Steuereinheit verbindet, wobei die Schaltungsanordnung eine zweite Detektionsvorrichtung zur Detektion eines Brands im Schaltschrank aufweist, wobei die Schaltungsanordnung einen zweiten Erfassungspfad zur Signalisierung eines Fehlerfalls an die Steuereinheit aufweist, der mindestens einen Ausgang der zweiten Detektionsvorrichtung mit einem zweiten Eingang der Steuereinheit verbindet, wobei die Steuereinheit derart ausgestaltet ist, dass bei Signalisierung eines Fehlerfalls am ersten Eingang der Steuereinheit und/oder bei Signalisierung eines Fehlerfalls am zweiten Eingang der Steuereinheit am Ausgang der Steuereinheit ein Alarm signalisiert wird.

## Beschreibung

Die Erfindung betrifft ein System mit einem offenen Schaltschrank, insbesondere für ein Schienenfahrzeug, nach dem Oberbegriff des Anspruchs 1.

Ein derartiges System umfasst einen Schaltschrank mit einer Öffnung zur Kühlung, ein Kühlsystem und eine Schaltungsanordnung zur sicherheitsgerichteten Steuerung des Kühlsystems, wobei die Schaltungsanordnung eine erste Detektionsvorrichtung zur Detektion eines Brands im Schaltschrank und eine Steuereinheit aufweist, wobei ein Ausgang der Steuereinheit mit dem Kühlsystem verbunden ist. Die Schaltungsanordnung weist einen ersten Erfassungspfad zur Signalisierung eines Fehlerfalls an die Steuereinheit auf, der einen Ausgang der ersten Detektionsvorrichtung mit einem ersten Eingang der Steuereinheit verbindet.

Elektrische und elektronische Baugruppen werden in der Regel in Schaltschränken angeordnet. Zur Abfuhr der beim Betrieb im Schaltschrank entstehenden Wärme ist eine Kühlung des Schaltschrankes erforderlich. Gleichzeit bestehen, insbesondere bei Schaltschränken in Schienenfahrzeugen, hohe Anforderungen an die Brandsicherheit.

Zur Realisierung der hohen Brandsicherheit werden Schaltschränke mit elektrischen und elektronischen Baugruppen zum Beispiel als hermetisch abgeschlossene Gehäuse installiert, die in der Regel aus metallischen Werkstoffen aufgebaut sind. Die Entwärmung solcher geschlossener Schaltschränke erfolgt über Wärmetauscher oder über freie Konvektion. Nachteilig am Einsatz von zum Beispiel unter Verwendung von Kühlkörpern mit Kühlrippen ausgebildeten Wärmetauschersystemen ist jedoch ihr begrenztes Wärmeableitvermögen sowie ihr durch voluminöse Kühlrippen bedingtes hohes Eigengewicht. Auch verschmutzen die schmalrippigen Kühlkörper vergleichsweise schnell, so dass kürzere Reinigungsintervalle notwendig werden. Auch bei einer Wärmeableitung mittels freier Konvektion ist das Wärmeableitvermögen aufgrund der konstruktiv bedingten Oberfläche begrenzt. Insbesondere in den Sommermonaten kann die Innentemperatur solcher Schaltschränke thermische Grenzbereiche tangieren. Dies erhöht den thermischen Stressfaktor für die elektrischen und elektronischen Komponenten und setzt die Zuverlässigkeit und Verfügbarkeit des Systems herab.

Sogenannte offene Schaltschränke weisen - im Vergleich zu hermetisch abgeschlossenen Systemen - Öffnungen zur Zuleitung von Umgebungslauft auf, die aktiv über Lüfter angesaugt wird. Dies erlaubt eine effiziente Kühlung der im Schaltschrank angeordneten Baugruppen. Im Brandfall wird allerdings eine effiziente Abschottung des Schaltschranks notwendig. Aufgrund der offenen Verbindung zwischen Schaltschrankinnenraum und, bei Anordnung in einem Schienenfahrzeug, Fahrgastinnenraum sind zur Gewährleistung der Brandsicherheit hohe Anforderungen an die Zuverlässigkeit der Detektion eines Brandes und an die Sicherheit der Steuerung der Brandabschottung zu erfüllen.

Detektion und Brandabschottung offener Schaltschränke erfolgt häufig durch Brandmeldezentralen, die die einzelnen Sicherheitskomponenten wie Abschottungs-, Alarmierungs- und Anzeigekomponenten ansteuern. Brandmeldezentralen sind zumeist Bestandteil einer höher geordneten Steuerungsebene einer Anlage und regelmäßig aus rechnerbasierten Komponenten aufgebaut, was eine entsprechende Software bedingt. Die Detektion eines Brandfalls erfolgt dabei mit Hilfe von im oder am Schaltschrank angeordneten Temperatursensoren.

Aufgabe der vorliegenden Erfindung ist es, ein System mit einem offenen Schaltschrank, insbesondere für ein Schienenfahrzeug, zur Verfügung zu stellen, das die Brandsicherheit des Schaltschranks gegenüber dem Stand der Technik erhöht.

Diese Aufgabe wird durch ein System mit den Merkmalen des Anspruchs 1 gelöst.

Demnach weist das System eine Schaltungsanordnung mit einer zweiten Detektionsvorrichtung zur Detektion eines Brands im Schaltschrank auf, wobei die Schaltungsanordnung einen zweiten, vom ersten Erfassungspfad getrennten, Erfassungspfad zur Signalisierung eines Fehlerfalls an die Steuereinheit aufweist, der mindestens einen Ausgang der zweiten Detektionsvorrichtung mit einem zweiten Eingang der Steuereinheit verbindet, wobei die Steuereinheit derart ausgestaltet ist, dass bei Signalisierung eines Fehlerfalls am ersten Eingang der Steuereinheit und/oder bei Signalisierung eines Fehlerfalls am zweiten Eingang der Steuereinheit am Ausgang der Steuereinheit ein Alarm signalisiert wird.

Mit der zweiten Detektionsvorrichtung und dem zweiten Erfassungspfad wird ein vom ersten Erfassungspfad getrennter Erfassungspfad zur Detektion und Erfassung eines Fehlerfalls zur Verfügung gestellt. Die Erfassung des Fehlerfalls erfolgt auf getrennten Pfaden. Da die Steuereinheit sowohl bei Signalisierung eines Fehlerfalls im ersten als auch bei Signalisierung eines Fehlerfalls im zweiten Erfassungpfad einen Alarm signalisiert, sind die beiden Erfassungspfade redundant. Die diversitäre und redundante Erfassung eines Fehlerfalls erhöht die Ausfallsicherheit eines Systems. Hierdurch wird die Gefährdung, insbesondere von Personen und Sachwerten in einem Schienenfahrzeug, durch einen Brand im Schaltschrank verringert. Insbesondere ist gewährleistet, dass auch bei Ausfall oder Fehlfunktion einer der beiden Detektionsvorrichtungen ein Brand erkannt, ein Alarmsignal ausgelöst und eine entsprechende sicherheitsgerichtete Reaktion eingeleitet werden kann.

Die erste und zweite Detektionsvorrichtung können im Schaltschrank oder in der Umgebung des Schaltschranks angeordnet sein. Eine außerhalb des Schaltschranks angeordnete Detektionsvorrichtung wird durch einen Brand im Schaltschrank weniger schnell beschädigt. Eine Anordnung im Schaltschrank ermöglicht demgegenüber eine frühere und zuverlässigere Detektion eines Brandes. Durch die Anordnung zum Beispiel einer der beiden Detektionsvorrichtungen im Schaltschrank und einer der beiden Detektionsvorrichtungen außerhalb des Schaltschranks können beispielsweie die Vorteile beider Anordnungsmöglichkeiten kombiniert werden.

Erfindungsgemäß ist ein Ausgang der ersten Detektionsvorrichtung mit einem ersten Eingang der Steuereinheit über einen ersten Erfassungspfad, beispielsweise eine Zuleitung, verbunden. Zusätzlich können im ersten Erfassungspfad ein oder mehrere Schaltungen angeordnet sein. Der Ausgang der zweiten Detektionsvorrichtung ist über den zweiten Erfassungspfad, beispielsweise durch ein oder mehrere Zuleitungen, mit dem zweiten Eingang der Steuereinheit verbunden. Zusätzlich können im zweiten Erfassungspfad ein oder mehrere Schaltungen angeordnet sein.

Bei Detektion eines Brands durch die erste Detektionsvorrichtung gibt die erste Detektionsvorrichtung ein entsprechendes Fehlersignal in den ersten Erfassungspfad. Über den ersten Erfassungspfad gelangt das Fehlersignal an den ersten Eingang der Steuereinheit und wird hier mit einem etwaig durch die zweite Detektionsvorrichtung über den zweiten Erfassungspfad dem zweiten Eingang der Steuereinheit zugeleiteten Fehlersignal verknüpft. Dabei ist bereits das Vorliegen eines Fehlersignals an einem der beiden Eingänge ausreichend, um ein Alarmsignal auszulösen.

Über die Verbindung zwischen Steuereinheit und Kühlsystem löst das Alarmsignal eine sicherheitsgerichtete Reaktion aus. Eine sicherheitsgerichtete Reaktion umfasst beispielsweise eine Ansteuerung des Kühlsystems, so dass eine Gefährdung, insbesondere von Personen und Sachwerten in einem Schienenfahrzeug, durch einen Brand im Schaltschrank verringert wird.

Gemäß einer Ausführungsform weist das Kühlsystem mindestens einen der Öffnung des Schaltschranks zugeordneten Lüfter, ein Schottsystem zur Abschottung des Schaltschranks und eine Kühlsystemsteuerung zur Steuerung des mindestens einen Lüfters und des Schottsystems auf.

Der mindestens eine Lüfter saugt Luft aus dem Außenraum des Schaltschranks an und führt diese dem Schaltschrankinnenraum zu. Dies ermöglicht eine effiziente Entwärmung des Schaltschranks.

Das Schottsystem ermöglicht eine (hermetische) Abschottung des Schaltschranks gegenüber dem Außenraum, bevorzugt durch ein Verschließen der mindestens einen Öffnung des Schaltschranks. Das Schottsystem ist bevorzugt elektrisch steuerbar und wird über die Kühlsystemsteuerung angesteuert.

Das Vorliegen eines Alarmsignals am Ausgang der Steuereinheit löst bevorzugt eine sicherheitsgerichtete Reaktion durch Ansteuerung des Kühlsystems über die Verbindung zwischen Steuereinheit und Kühlsystemsteuerung aus. Beispielsweise kann als sicherheitsgerichtete Reaktion der mindestens eine Lüfter abgeschaltet und/oder der Schaltschrank mittels des Schottsystems abgeschottet werden. Die Luftzufuhr zum Schaltschrank wird hierdurch im Falle eines Brands verringert und ein weiteres Anfachen des Brandes unterbunden. Die Abschottung des Schaltschranks verhindert ein Austreten von Flammen, Rauch und Hitze aus dem Schaltschrank und verhindert zudem eine Luftzufuhr in den Innenraum des Schaltschranks.

Das Schottsystem weist beispielsweise ein Schiebegitter auf, das über einen Schub-, Zug- oder Hubmagneten verschlossen bzw. geöffnet wird. Der Schub-. Zug- oder Hubmagnet wird bevorzugt von der Kühlsystemsteuerung angesteuert.

Gemäß einer Ausführungsform ist die Steuereinheit in einem zentralen Steuerrechner (HSDR) eines Schienenfahrzeugs angeordnet. Der zentrale Steuerrechner weist eine zentrale Recheneinheit (central processing unit, CPU) zur Signalverarbeitung auf. Der zentrale Steuerrechner ist bevorzugt an ein BUS-System des Schienenfahrzeugs gekoppelt. Bei Vorliegen eines Alarmsignals am Ausgang der Steuereinheit kann so eine sicherheitsgerichtete Reaktion an allen Fahrzeugkomponenten ausgelöst werden. Die Ansteuerung des Kühlsystems erfolgt dann bevorzugt ebenfalls über das BUS-System.

Gemäß einer Ausführungsform erfolgt die Signalisierung des Fehlerfalls im ersten und im zweiten Erfassungspfad low-aktiv. Das heisst, die Detektion eines Brands durch die erste bzw. durch die zweite Detektionsvorrichtung wird im ersten bzw. zweiten Erfassungspfad durch einen low-Pegel (L-Pegel) erfasst. Bevorzugt wird das Auftreten eines Fehlerfalls, beispielsweise durch Detektion eines Brands, im gesamten ersten und im gesamten zweiten Erfassungspfad durch einen L-Pegel repräsentiert. Durch die low-aktive Signalisierung des Fehlerfalls können Kurzschluss und Unterbrechungen im ersten und zweiten Erfassungspfad, insbesondere in den Zuleitungen der beiden Erfassungspfade, sicher detektiert werden. Bevorzugt schalten die erste bzw. die zweite Detektionsvorrichtung bei Detektion eines Fehlers aus. Dies hat den Vorteil, dass ein Stromausfall und/oder Spannungsabfall als Fehlerfall gewertet wird. Die Signalisierung eines Stromausfalls und/oder Spannungsabfalls als Fehlerfall erfolgt somit automatisch. Dies erhöht die Zuverlässigkeit der Branddetektion gegenüber einer high-aktiven Erfassung.

Gemäß einer Ausführungsform weist die erste Detektionsvorrichtung mindestens einen Temperaturfühler auf. Der mindestens eine Temperaturfühler misst die Raumtemperatur in einer Umgebung der ersten Detektionsvorrichtung. Das Überschreiten eines Schwellenwerts und/oder ein steiler Anstieg der gemessenen Temperatur lösen beispielsweise eine Detektion eines Brandes aus. Der mindestens eine Temperaturfühler weist einen Temperatursensor und ein Ausgaberelais mit Ausgabekontakt auf. In einer Ausgestaltung weist die erste Detektionsvorrichtung zwei Temperaturfühler auf. Die beiden Temperaturfühler sind bevorzugt so geschaltet, dass zur Signalisierung eines Fehlerfalls im ersten Erfassungspfad ein Anschlagen eines der beiden Temperaturfühler ausreicht. Die Detektion eines Brands durch die erste Detektionsvorrichtung erfolgt somit redundant. Der zweite Temperaturfühler stellt eine sensorische Rückfallebene dar. Dies erhöht die Ausfallsicherheit der Detektionsvorrichtung und die Sicherheit der gesamten Schaltungsanordnung.

Die beiden Temperaturfühler sind bevorzugt in Reihe geschaltet. Die Signalerfassung an dem jeweiligen Ausgabekontakt des Temperaturfühlers erfolgt low-aktiv.

Gemäß einer Ausführungsform weist die zweite Detektionsvorrichtung einen Rauchmelder auf, und der mindestens eine Ausgang der zweiten Detektionsvorrichtung ist ein Ausgang zur Signalisierung einer Rauchentwicklung durch den Rauchmelder. Bei einem Brand treten kleine Rauchpartikel in einem sehr frühen Stadium der Brandentwicklung auf, häufig bereits bevor es zu einer nennenswerten Temperaturentwicklung kommt. Der Rauchmelder ermöglicht somit die frühe Detektion von Bränden sowie die Detektion von Bränden ohne nennenswerte Temperaturentwicklung wie beispielsweise Schwelbrände.

Der Rauchmelder der zweiten Detektionsvorrichtung ermöglicht in einer Ausführungsform zusammen mit dem Temperaturfühler der ersten Detektionsvorrichtung eine nicht nur redundante, sondern auch diversitäre Branddetektion. Sowohl Brände mit Temperaturentwicklung und vergleichsweise niedriger Rauchentwicklung als auch Brände mit Rauchentwicklung und vergleichsweise niedriger Temperaturentwicklung werden so mit hoher Wahrscheinlichkeit detektiert.

Bevorzugt weist die zweite Detektionsvorrichtung mindestens einen weiteren Sensor zur Detektion eines Brands, beispielsweise einen Temperatursensor, auf. Die zweite Detektionsvorrichtung weist beispielsweise einen Mehrfachsensorbrandmelder auf. Bevorzugt ist die zweite Detektionsvorrichtung ein Brandmelder mit integriertem Übertemperatursensor Typ SD9475-03. Hierdurch wird eine weitere sensorische Rückfallebene geschaffen und die Zuverlässigkeit der Detektion weiter erhöht.

Gemäß einer Ausführungsform weist die zweite Detektionsvorrichtung eine Überwachungseinheit zur Überwachung der Funktionsfähigkeit der zweiten Detektionsvorrichtung und mindestens einen Überwachungsausgang zur Signalisierung eines Störzustands der zweiten Detektionsvorrichtung auf, wobei der mindestens eine Überwachungsausgang zur Signalisierung des Störzustands über den zweiten Erfassungspfad mit dem zweiten Eingang der Steuereinheit verbunden ist. Die Signalisierung des Störzustands umfasst beispielsweise die Signalisierung eines Lebenszeichen-Signals und/oder die Signalisierung einer Verschmutzung des Rauchmelders. Hierdurch wird die Detektion eines Brandfalls um die Detektion eines Störungsfalls ergänzt.

Gemäß einer Ausführungsform weist der zweite Erfassungspfad zwischen zweiter Detektionsvorrichtung und Steuereinheit eine Diagnosebaugruppe zur Verarbeitung der Ausgangssignale der zweiten Detektionsvorrichtung auf, wobei der mindestens eine Ausgang zur Signalisierung einer Rauchentwicklung mit einem ersten Eingang der Diagnosebaugruppe verbunden ist und der mindestens eine Überwachungsausgang zur Signalisierung eines Störzustands der zweiten Detektionsvorrichtung mit einem zweiten Eingang der Diagnosebaugruppe verbunden ist und ein Ausgang der Diagnosebaugruppe mit dem zweiten Eingang der Steuereinheit verbunden ist. Dies ermöglicht eine Plausibilitätsprüfung einer detektierten Rauchentwicklung. Die Diagnosebaugruppe ist bevorzugt zwischen zweiter Detektionsvorrichtung und Steuereinheit angeordnet. Die Diagnosebaugruppe verknüpft das vom Rauchmelder abgegebene Signal mit dem Störungssignal. Bevorzugt weist die zweite Detektionsvorrichtung einen ersten Ausgang zur Signalisierung von Rauch und einen ersten und zweiten Überwachungsausgang zu Signalisierung von Verschmutzung des Rauchmelders und zur Signalisierung eines Lebenszeichens der zweiten Detektionsvorrichtung auf. Die entsprechenden Signale werden in der Diagnosebaugruppe verknüpft und ausgewertet und an den zweiten Eingang der Steuereinheit gegeben. Die Erfassung der jeweiligen Signale durch die Diagnosebaugruppe erfolgt bevorzugt low-aktiv. Über die Verbindung zu dem zweiten Eingang der Steuereinheit ist die Diagnosebaugruppe über einen ersten Ansteuerpfad mit der Kühlsystemsteuerung verbunden.

Gemäß einer Ausführungsform ist die Diagnosebaugruppe über einen zweiten Ansteuerpfad mit der Kühlsystemsteuerung verbunden. Die Diagnosebaugruppe und die Kühlsystemsteuerung sind beispielsweise über ein Verbindungskabel miteinander verbunden. Der zweite Ansteuerpfad stellt einen redundanten Ansteuerpfad dar. Dies erhöht die Ausfall- und Betriebssicherheit des Systems.

Gemäß einer Ausführungsform weist die Diagnosebaugruppe eine Zusatzbaugruppe zur Überwachung von Kurzschluss und/oder Unterbrechung auf. Bei Kurzschluss oder Unterbrechung in der Diagnosebaugruppe unterbricht die Zusatzbaugruppe den zweiten Ansteuerpfad. Bevorzugt erfolgt zusätzlich die Signalisierung eines Fehlerfalls über den Ausgang der Diagnosebaugruppe an die Steuereinheit.

Gemäß einer Ausführungsform weist die Diagnosebaugruppe eine Auswerteschaltung zur Verknüpfung der am ersten und zweiten Eingang der Diagnosebaugruppe eingehenden Signale auf, wobei die Auswerteschaltung derart ausgestaltet ist, dass bei Signalisierung einer Rauchentwicklung am ersten Eingang und/oder bei Signalisierung eines Störzustands am zweiten Eingang ein Fehlerfall am zweiten Eingang der Steuereinheit signalisiert wird. Der Fehlerfall umfasst somit neben dem Brandfall auch den Störungsfall. Die Auswerteschaltung weist bevorzugt eine Selbsttesterkennung auf. Bevorzugt ist die Auswerteschaltung fest verdrahtet.

In einer Ausgestaltung bilden zweite Detektionsvorrichtung und Auswerteschaltung, insbesondere der Rauchmelder der zweiten Detektionsvorrichtung, eine Kompakteinheit. Die Ausgestaltung von zweiter Detektionsvorrichtung und Auswerteschaltung als Kompakteinheit bedingt eine Anordnung der zweiten Detektionsvorrichtung im Schaltschrank, beispielsweise im Luftstrom und/oder oberhalb der gewöhnlicherweise im Schaltschrank angeordneten elektrischen und elektronischen Baugruppen.

In einer alternativen Ausgestaltung sind zweite Detektionsvorrichtung, insbesondere der Rauchmelder der zweiten Detektionsvorrichtung, und Auswerteschaltung nicht als Kompakteinheit ausgeführt. In dieser Ausgestaltung ist eine Anordnung der zweiten Detektionsvorrichtung im Schaltschrank oder außerhalb des Schaltschranks möglich.

Gemäß einer Ausführungsform weist die Diagnosebaugruppe ein remanentes Speicherelement zur Speicherung des Fehlerfalls auf. Im remanenten Speicherelement bleibt auch beim Fortfall einer speisenden Spannung der Fehlerfall, d.h. Brandfall oder Störungsfall, bis zur Rücksetzung gespeichert. Zur Rücksetzung weist das remanente Speicherelement bevorzugt einen Schalter auf. Der Schalter kann manuell oder über eine Schnittstelle per Fernbedienung geschaltet werden. Die Rücksetzung des Schalters stellt eine Quittierung des Fehlerfalls da. Somit wird verhindert, dass ein detektierter Brand- und/oder Störzustand der zweiten Detektionsvorrichtung unbemerkt bleibt. Bevorzugt weist das remanente Speicherelement ein Remanenzrelais auf. Dem Remanenzrelais kann ein Schaltverstärker vorgeschaltet sein.

Gemäß einer Ausführungsform weist die Diagnosebaugruppe eine Testschaltung zur Überprüfung der zweiten Detektionsvorrichtung und der Diagnosebaugruppe auf, wobei bei Auslösen der Testschaltung die Signalisierung einer Rauchentwicklung und/oder die Signalisierung eines Störzustands simuliert werden. Die Testschaltung wird bevorzugt durch Testschalter angesteuert. Die Testschalter können manuell oder über eine Schnittstelle per Fernbedienung angesteuert werden. Bevorzugt kann jedes Signal getrennt simuliert werden.

Gemäß einer Ausführungsform weist die Diagnosebaugruppe eine Schnittstelle zur Verbindung mit einem externen Rechner zur Ansteuerung der Testschaltung auf. Bevorzugt ist die Schnittstelle als CAN-Schnittstelle (controller area network-bus) ausgeführt. Dies ermöglicht eine einfache und schnelle Wartung und Überprüfung des Systems, insbesondere der zweiten Detektionsvorrichtung und der Diagnosebaugruppe. Gemäß einer Ausführungsform weist die Kühlsystemsteuerung eine Antibetauungsschaltung auf, die den mindestens einen Lüfter und das Schottsystem so schaltet, dass Betauungszustände im Schaltschrank vermieden werden. Die Antibetauungsschaltung verhindert eine Kondensatbildung auf im Schaltschrank üblicherweise angeordneten elektrischen und elektronischen Baugruppen. Durch Kondensatbildung ausgelöste Kurzschlüsse werden somit vorteilhaft vermieden.

Der der Erfindung zugrunde liegende Gedanke soll nachfolgend anhand der in den Figuren dargestellten Ausführungsbeispiele näher erläutert werden. Es zeigen:
- Fig. 1: eine schematische Darstellung eines Systems mit einem offenen Schaltschrank für ein Schienenfahrzeug, einem Kühlsystem und einer Schaltungsanordnung zur sicherheitsgerichteten Steuerung des Kühlsystems;
- Fig. 2: einen Schaltplan des zweiten Erfassungspfads mit zweiter Detektionsvorrichtung und Kühlsystem gemäß einer bevorzugten Ausführungsform; und
- Fig. 3: ein Kennlinienfeld zur Einstellung des Grundluftvolumens bei Inbetriebnahme des Kühlsystems in einem möglichen Umgebungstemperaturintervall im Schaltschrank.

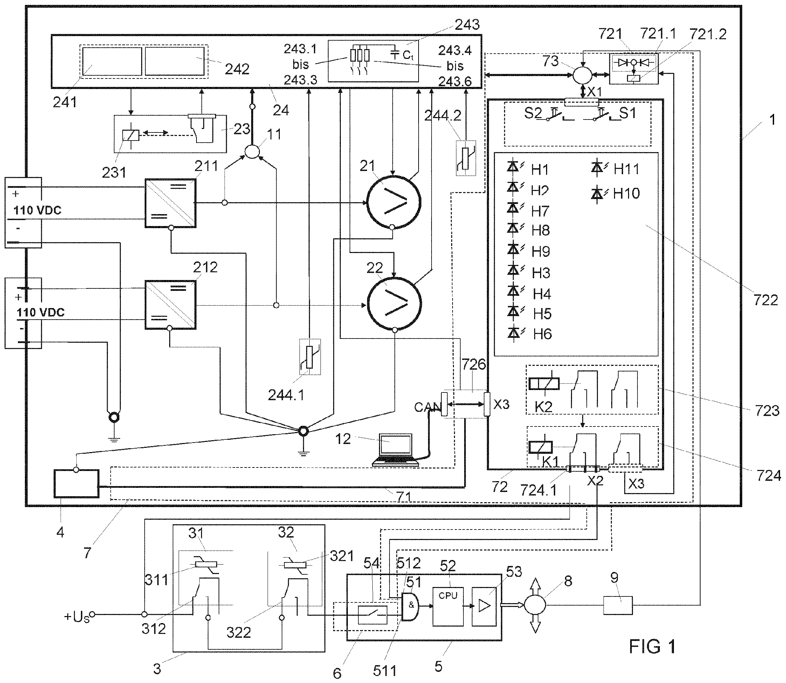

**Fig.** 1 zeigt in einer schematischen Darstellung ein Ausführungsbeispiel eines Systems mit einem offenen Schaltschrank 1 für ein Schienenfahrzeug. Der Schaltschrank 1 weist eine Öffnung zur Kühlung des Schaltschrankinnenraums auf. Zusätzlich weist das System ein Kühlsystem zur aktiven Kühlung des Schaltschranks 1 auf. Das Kühlsystem umfasst mindestens einen der Öffnung zugeordneten Lüfter 21, 22, der Luft aus einem Außenraum des Schaltschranks 1 ansaugt. Bevorzugt weist das Kühlsystem einen ersten und einen zweiten Lüfter 21, 22 zur effizienten Kühlung des Schaltschranks 1 auf.

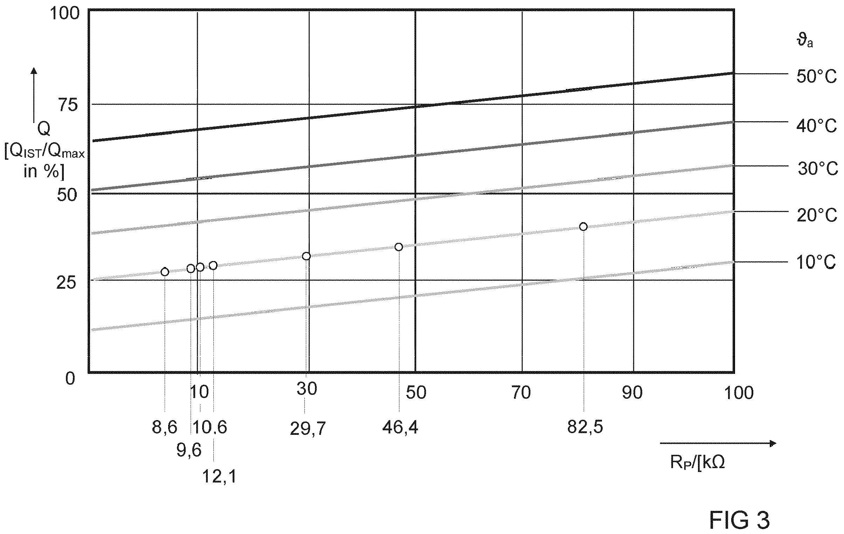

Die Lüfter 21, 22 werden über die Kühlsystemsteuerung 24 angesteuert. Bevorzugt weist die Kühlsystemsteuerung eine temperaturgesteuerte Lüftersteuerung auf. Im Schaltschrank 1 angeordnete Temperaturfühler 244.1, 244.2 erfassen die Temperatur im Innenraum des Schaltschranks 1. In Abhängigkeit von der gemessenen Temperatur erfolgt die Einstellung der zugeführten Luftmenge mittels Pulsweitenmodulation (PWM), 243. Die PWM 243 wird aus einer redundanten Stromversorgung gespeist. Hierdurch wird die Betriebssicherheit des Kühlsystems sichergestellt. Der Luftvolumenstrom wird durch die Grundzeitkonstante der PWM 243 bestimmt. Die Grundzeitkonstante der PWM 243 wird kombinatorisch durch Aktivieren der Schalter 6.3.4, 6.3.5, 6.3.6 und damit der den Schaltern 6.3.4, 6.3.5, 6.3.6 zugeordneten Widerstände 6.3.1, 6.3.2, 6.3.3 eingestellt. Durch Parallelschaltung der Widerstände 6.3.1, 6.3.2, 6.3.3 ergeben sich verschiedene Widerstandskombinationen. Im dargestellten Ausführungsbeispiel lassen sich mit den drei Widerständen 6.3.1, 6.3.2, 6.3.3 acht Widerstandskombinationen und damit acht Grundzeitkonstanten der PWM 243 einstellen. Der durch eine bestimmte Widerstandskombination erreichte Luftvolumenstrom ist anlagenbedingt, d.h. von den baulichen Gegebenheiten des Schaltschranks 1, abhängig. Außerdem hängt der bei einer bestimmte Widerstandskombination erzeugte Luftvolumenstrom von der Umgebungstemperatur während des Einstellvorgangs ab. Die Einstellung des Grundluftvolumens erfolgt unter Berücksichtigung des entsprechenden Kennlinienfelds zur Einstellung des Grundluftvolumens bei Inbetriebnahme des Kühlsystems in einem möglichen Umgebungstemperaturintervall. Das Kennlinienfeld ist für die dargestellte Ausführungsform beispielhaft in **Fig. 3** gezeigt. Für diskrete Temperaturwerte im Intervall zwischen 10°C und 50°C zeigt das Kennlinienfeld den mit einer bestimmten Widerstandskombination Rₚ erzeugten Luftvolumenstrom Q.

Der erste bzw. zweite Lüfter 21, 22 wird über einen ersten bzw. zweiten DC/DC-Wandler 211, 212 mit einer Spannung von 24 VDC versorgt.

Das Kühlsystem ermöglicht aufgrund der aktiven Kühlung mittels der Lüfter 21, 22 eine effiziente Kühlung des Schaltschrankinnenraums. Kommt es zu einem Brand im Schaltschrankinnenraum, können Flammen, Rauch und Hitze durch die Öffnung des Schaltschranks 1 nach außen dringen. Auch wird durch die von den Lüftern 21, 22 angesaugte Luft der Brand weiter angefacht. Ist der Schaltschrank 1 beispielsweise in oder benachbart zu einem Fahrgastinnenraum eines Schienenfahrzeugs angeordnet und erfolgt die Belüftung aus dem Fahrgastinnenraum, stellt dies eine konkrete Gefährdung von Personen und Sachwerten dar.

Zur Verringerung der Gefährdung und zur Erhöhung der Brandsicherheit weist das Kühlsystem ein Schottsystem 23 zur Abschottung, insbesondere zur Brandabschottung, des Schaltschranks 1 auf. Das Schottsystem 23 wird über eine Schottsystemsteuerung 242 der Kühlsystemsteuerung 24 angesteuert. Das Schottsystem 23 ist bevorzugt elektrisch steuerbar. Das Schottsystem 23 weist zur Abschottung, insbesondere zum Verschließen der Öffnung des Schaltschranks 1, ein Schiebegitter (nicht gezeigt) auf. Das Schiebegitter wird bevorzugt durch einen Hub-, Schub- oder Zugmagneten 231 mit stromloser geschlossener Ruhelage angesteuert. Im Normalbetrieb ist das Schottsystem 23, insbesondere das Schiebegitter, offen. Im Brandfall wird das Schottsystem 23 ausgelöst. Schaltschrank 1 ist gegenüber seiner Umgebung, beispielsweise einem Fahrgastinnenraum eines Schienenfahrzeugs, abgeschottet.

Der Brandfall wird durch eine erste Detektionsvorrichtung 3 detektiert und über einen ertsen Erfassungspfad 6 an eine Steuereinheit 51 gegeben. Die Steuereinheit 51 ist bevorzugt in einem zentralen Steuerrechner 5, insbesondere eines Schienenfahrzeugs, angeordnet. Der zentrale Steuerrechner 5 weist eine zentrale Recheneinheit (central processing unit, CPU) 52 auf, in der das eingehende Signal digital verarbeitet und über einen BUS-Treiber 53 des zentralen Steuerrechners 5 an einen BUS-Koppler 8 gegeben wird. Bevorzugt erfolgt so die weitere Signalisierung über ein BUS-System, insbesondere das BUS-System eines Schienenfahrzeugs. Über das BUS-System wird die Kühlsystemsteuerung 24 angesprochen und die Schottsystemsteuerung 242 löst das Schottsystem 23 aus.

Zur Erhöhung der Brandsicherheit weist das System eine zweite Detektionsvorrichtung 4 zur Detektion eines Brands im Schaltschrank 1 auf. Ein durch die zweite Detektionsvorrichtung 4 detektierter Brand wird der Steuereinheit 51 über einen zweiten Erfassungspfad 7 signalisiert. Die Steuereinheit 51 ist über einen ersten Eingang 511 mit dem ersten Erfassungspfad 6 und somit der ersten Detektionsvorrichtung 3 verbunden. Die Steuereinheit ist über einen zweiten Eingang 512 mit dem zweiten Erfassungspfad 7 und somit mit der zweiten Detektionsvorrichtung 4 verbunden. Die Steuereinheit 51 ist so ausgestaltet, dass bei Signalisierung eines Brandfalls am ersten Eingang 511 und/oder am zweiten Eingang 512 ein Alarmsignal ausgegeben wird. Die weitere Signalisierung erfolgt über die CPU 52, BUS-Treiber 53 und BUS-Koppler 8 über das BUS-System, insbesondere das BUS-System eines Schienenfahrzeugs, an die Kühlsystemsteuerung 24. Die Schottsystemsteuerung 242 der Kühlsystemsteuerung 24 löst das Schottsystem 23 aus.

Mit der zweiten Detektionsvorrichtung 4 und dem zweiten Erfassungspfad 7 wird ein vom ersten Erfassungspfad 6 getrennter Erfassungspfad zur Detektion und Erfassung eines Brands im Schaltschrank 1 zur Verfügung gestellt. Durch die erfindungsgemäße Verknüpfung der eingehenden Signale in der Steuereinheit 51 sind der erste und zweite Erfassungspfad 7 nicht nur getrennt, sondern auch redundant: die Detektion eines Brands in einem der beiden Erfassungspfade 6, 7 ist ausreichend, um ein Alarmsignal und damit eine sicherheitsgerichtete Reaktion in Form der Abschottung durch das Schottsystem 23 auszulösen. Hierdurch wird die Ausfall- und Betriebssicherheit des Systems erhöht, das Gefährdungspotential weiter reduziert.

Die Erfassung eines Fehlerfalls, d.h. eines Brandfalls und/oder eines Störfalls der zweiten Detektionsvorrichtung 4, erfolgt im ersten und im zweiten Erfassungspfad 7 low-aktiv. Der Fehlerfall, d.h. der Brandfall und/oder der Störungsfall der zweiten Detektionsvorrichtung 4, wird durch einen low-Pegel (L-Pegel), insbesondere an dem jeweiligen Ausgang der den Fehlerfall detektierenden ersten und/oder zweiten Detektionsvorrichtung 3, 4, repräsentiert. Im Fehlerfall, d.h. im Brandfall und/oder der Störfall der zweiten Detektionsvorrichtung 4, liegt L-Pegel am ersten und/oder zweiten Eingang 511, 512 der Steuereinheit 51 an. Die Steuereinheit 51 weist eine UND-Verknüpfung auf. Die Detektion eines Brands durch die erste und/oder durch die zweite Detektionsvorrichtung 3, 4 führt somit zu einem L-Pegel am Ausgang der Steuereinheit 51. Die low-aktive Erfassung der Signale ermöglicht eine sichere Detektion von Kurzschluss und Unterbrechungen im ersten und/oder zweiten Erfassungspfad 6, 7.

Die erste Detektionsvorrichtung 3 weist mindestens einen Temperaturfühler 31 auf. Der Temperaturfühler 31 detektiert eine etwaige mit einem Brand einhergehende Temperaturentwicklung, beispielsweise durch einen raschen Temperaturanstieg oder durch eine Übersteigung einer Schwelltemperatur. Die zweite Detektionsvorrichtung 4 weist bevorzugt einen Rauchmelder auf. Der Rauchmelder detektiert bei einem Brand entstehende, kleine Rauchpartikel. Die erste und zweite Detektionsvorrichtung 3, 4 sind somit beide geeignet, einen Brand im Schaltschrank 1 zu detektieren. Die Detektion erfolgt aber über unterschiedliche Messgrößen. Die Detektion eines Brandes erfolgt somit diversitär. Auch hierdurch wird die Brandsicherheit des Systems weiter erhöht. Beispielsweise wird sicherstellt, dass sowohl Brände mit einer Temperatur-, aber vergleichsweise niedrigen Rauchentwicklung als auch Brände mit einer Rauch-, aber vergleichsweise niedrigen Temperaturentwicklung wie Schwelbrände, zuverlässig erkannt werden.

Die erste Detektionsvorrichtung 3 weist bevorzugt mindestens zwei Temperaturfühler 31, 32 auf. Der erste und zweite Temperaturfühler 31, 32 sind so geschaltet, dass die Detektion eines Brands durch den ersten und/oder durch den zweiten Temperaturfühler 31, 32 einer Detektion eines Brands durch die erste Detektionsvorrichtung 3 entspricht. Auch hierdurch wird eine zusätzliche Redundanz geschaffen. Es entsteht eine senorische Rückfallebene, die die Zuverlässigkeit der Branddetektion weiter erhöht und damit die Brandgefährdung verringert.

In der dargestellten Ausführungsform weist der erste Temperaturfühler 31 einen Temperatursensor 311 auf, der bei Auslösung ein Ausgaberelais 312 betätigt, woraufhin an einem Ausgabekontakt des Ausgaberelais die Branddetektion signalisiert wird. Entsprechend weist der zweite Temperaturfühler 32 einen Temperatursensor 321 auf, der bei Auslösung ein Ausgaberelais 322 betätigt, woraufhin an einem Ausgabekontakt des Ausgaberelais die Branddetektion signalisiert wird. Der erste und zweite Temperaturfühler 31, 32 sind in Reihe geschaltet.

Die zweite Detektionsvorrichtung 4 weist bevorzugt neben dem Rauchmelder ein Überwachungssystem zur Überwachung der Funktionsfähigkeit der ersten Detektionsvorrichtung 4 auf. Zusätzlich kann die zweite Detektionsvorrichtung 4 einen weiteren Detektor zur Branddetektion, beispielsweise einen Temperaturfühler, aufweisen. Eine zweite Detektionsvorrichtung 4 mit einem Rauchmelder und zusätzlichen Branddetektor ermöglicht eine redundante Detektion eines Brands. Ist der weitere Branddetektion kein Rauchmelder, sondern beispielsweise ein Temperaturfühler, erfolgt die Branddetektion durch die zweite Detektionsvorrichtung 4 außerdem diversitär. Eine redundante und diversitäre Branddetektion durch die zweite Detektionsvorrichtung 4 erhöht die Zuverlässigkeit des Systems. Die zweite Detektionsvorrichtung 4 ist beispielsweise ein Brandmelder, insbesondere ein Mehrfachsensorbrandmelder, bevorzugt ein Brandmelder mit integriertem Übertemperatursensor Typ SD9475-03.

Die zweite Detektionsvorrichtung 4 verfügt entsprechend jeweils über mindestens einen Ausgang des Rauchmelders, mindestens einen Überwachungsausgang der Überwachungseinheit und gegebenenfalls über mindestens einen Ausgang des weiteren Detektors. Der zweite Erfassungspfad 7 weist deshalb ein Verbundkabel 71 zur Verbindung der zweiten Detektionsvorrichtung 4, insbesondere aller Signalausgänge der zweiten Detektionsvorrichtung 4, mit einer Diagnosebaugruppe 72 auf.

Die Diagnosebaugruppe 72 ist im zweiten Erfassungspfad 7 zwischen zweiter Detektionsvorrichtung 4 und Steuereinheit 51 angeordnet und mit dem zweiten Eingang 512 der Steuereinheit 51 über eine Zuleitung verbunden.

Die Diagnosebaugruppe 72 ist außerdem, bevorzugt über ein Verbindungskabel 73, mit der Kühlsystemsteuerung 24 verbunden. Zwischen Diagnosebaugruppe 72 und Kühlsystemsteuerung 24 werden in beide Richtungen, von Kühlsystemsteuerung 24 zu Diagnosebaugruppe 72 und von Diagnosebaugruppe 72 zu Kühlsystemsteuerung 24, Signale übertragen. Bevorzugt ist eine Ansteuerung der Kühlsystemsteuerung 24, insbesondere der Schottsystemsteuerung 242, durch die Diagnosebaugruppe 72 möglich. Die Diagnosebaugruppe 72 und die Kühlsystemsteuerung 24 sind über einen Ansteuerpfad 73 miteinander verbunden.

Die Ansteuerung der Kühlsystemssteuerung 24 kann bevorzugt sowohl über die Steuereinheit 51, beispielsweise über das BUS-System, als auch über die Diagnosebaugruppe 72 erfolgen. Die Ansteuerung über die Diagnosebaugruppe 72 kann dabei nur auf Grundlage der von der zweiten Detektionsvorrichtung 4 empfangenen und verarbeiteten Signale erfolgen. Die erste Detektionsvorrichtung 3 bleibt in diesem Ansteuerpfad unberücksichtigt.

Bevorzugt weist die Diagnosebaugruppe 72 ausschließlich fest verdrahtete Schaltungen auf. Während der Ansteuerpfad über die Steuereinheit 51 auch software-basierte Komponenten, beispielsweise in Form der CPU 52, des BUS-Treibers und -Kopplers 53, 8, aufweist, ist der zweite Ansteuerpfad 73 frei von solchen Komponenten. Die beiden Ansteuerpfade sind somit redundant und diversitär. Insbesondere stellt die Verbindung zwischen Diagnosebaugruppe 72 und Kühlsystemsteuerung 24 sicher, dass eine Abschottung im Brandfall auch bei einer Störung des BUS-Systems, insbesondere des BUS-Systems des Schienenfahrzeugs, erfolgt. Die Ausfallsicherheit des Systems wird damit erhöht.

Die Diagnosebaugruppe 72 verarbeitet die von der zweiten Detektionsvorrichtung 4 eingehenden Signale, wertet diese aus und löst mindestens im Brandfall eine Ansteuerung der Kühlsystemsteuerung 24 über die Steuereinheit 51 und/oder direkt über das Verbindungskabel 73 aus. Die Diagnosebaugruppe 72 weist bevorzugt eine Testschaltung auf. Die Testschaltung wird über einen Schalter S1 angesteuert. Alternativ erfolgt die Ansteuerung der Testschalter über eine Schnittstelle X2 zur Fernbedienung der Tasterfunktion.

Die Diagnosebaugruppe 72 weist bevorzugt eine Anzeigevorrichtung 722 zur Statusanzeige der Komponenten des Systems, beispielsweise des ersten und zweiten Lüfters 21, 22, der zweiten Detektionsvorrichtung 4, der Steuerstromversorgung der zweiten Detektionsvorrichtung 4, des Schottsystems 23, des Betriebszustands der Diagnosebaugruppe 72 sowie eines Fehlerfalls der Diagnosebaugruppe 72 auf. Bevorzugt weist die Anzeigevorrichtung Leuchtdioden zur Statusanzeige, beispielsweise Leuchtdioden H1, H2 zur Statusanzeige des ersten und zweiten Lüfters 21, 22, Leuchtdioden H7, H8, H9 zur Statusanzeige der zweiten Detektionsvorrichtung 4, Leuchtdioden H3, H4 und H6 zur Statusanzeige des Schottsystems 23, Leuchtdiode H5 zur Statusanzeige der Steuerstromversorgung der zweiten Detektionsvorrichtung 4, Leuchtdiode H11 zur Statusanzeige des Betriebszustands der Diagnosebaugruppe 72 und Leuchtdiode H10 zur Statusanzeige eines Fehlerfalls in der Diagnosebaugruppe 72. Dabei signalisiert ein Leuchten der Leuchtdioden H7, H8 bzw. H9 Rauchentwicklung, Störung bzw. Verschmutzung der zweiten Detektionsvorrichtung 4. Ein Leuchten der Leuchtdioden H3, H4 bzw. H6 den Zustand 'Schiebegitter zu', 'Schiebegitter offen' und 'Hubmagnet ein'.

Die Diagnosebaugruppe 72 weist bevorzugt ein remanentes Speicherelement 723 zur Fehlerspeicherung und ein Ausgabeelement 724 zur Ausgabe an die Steuereinheit 51 auf. Zum Rücksetzen des remanenten Speicherelements 723 weist die Diagnosebaugruppe 72 einen Schalter S2 auf. Der Schalter S2 ist bevorzugt Teil der Anzeigevorrichtung 722. Das Ausgabeelement 724 weist einen Ausgang 724.1 zur Verbindung mit dem zweiten Eingang 512 der Steuereinheit 51 auf.

Die Diagnosebaugruppe 72 weist eine Zusatzbaugruppe 721 zur Überwachung von Kurzschluss und/oder Unterbrechungen auf. Die Zusatzbaugruppe 721 weist bevorzugt ein monostabiles Relais 721.2 auf, das über eine Dioden-UND-Matrix 721.1 angesteuert ab. Bei Kurzschluss oder Unterbrechung in der Diagnosebaugruppe 72 fällt das monostabile Relais 721.2 ab und unterbricht den Ansteuerpfad zwischen Diagnosebaugruppe 72 und Kühlsystemsteuerung 24, insbesondere die Schottsystemsteuerung 242. Ein Fehlersignal wird an der Anzeigevorrichtung 722 angezeigt. Die Leuchtdiode H10 zur Anzeige eines Fehlerfalls leuchtet auf. Über den Ausgang 724.1 wird ein Fehlersignal an den zweiten Eingang 512 der Steuereinheit 51, bevorzugt weiter an das BUS-System, insbesondere das BUS-System des Schienenfahrzeugs, gegeben.

Die Diagnosebaugruppe 72 weist bevorzugt eine Schnittstelle 726 zur Verbindung mit einem externen Rechner 12 auf. Bevorzugt ist die Schnittstelle als CAN-Schnittstelle (controller area network-bus) ausgeführt.

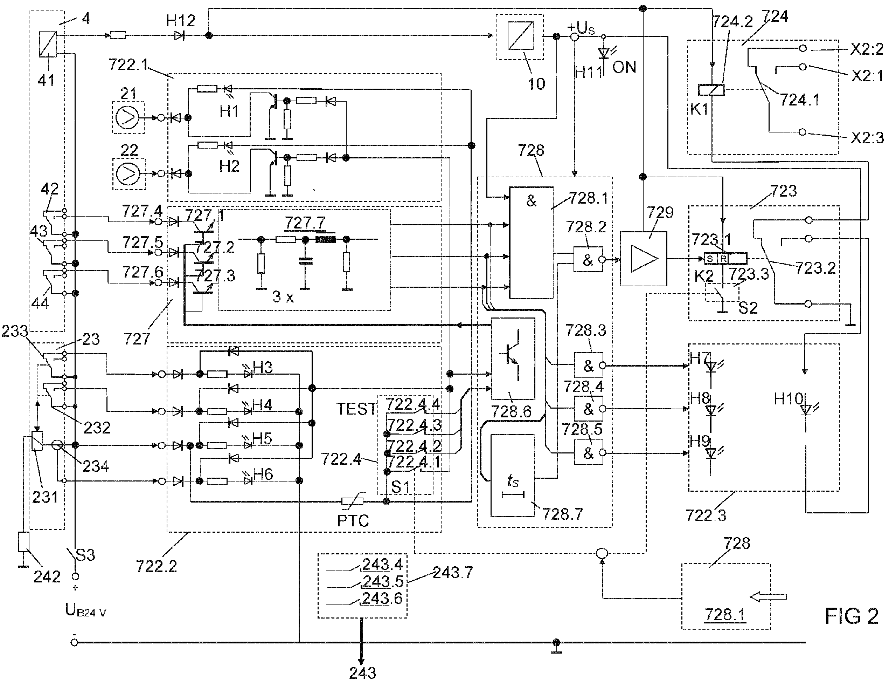

Der detailllierte Aufbau der Diagnosebaugruppe 72 in einer bevorzugten Ausgestaltung ist **Fig. 2** zu entnehmen.

In einer Ausgestaltung weist das System eine Montageplatte auf, auf der das Kühlsystem, insbesondere die Lüfter 21, 22, die Temperaturfühler 244.1, 244.2 der temperaturgesteuerten Kühlsystemsteuerung 24 und die Pulsweitenmodulation 243, die zweite Detektionsvorrichtung 4, die Zusatzbaugruppe 721, das Schottsystem 23, und die Diagnosebaugruppe 72, insbesondere die Anzeigevorrichtung 722 der Diagnosebaugruppe 72, sowie die Stromversorgung in vormontierter Weise angeordnet sind. Die Montageplatte mit den genannten Komponenten ist als 19"-Baugruppe an einer freien Stelle im zentralen Steuerrechner (HSDR) 5 angeordnet. Ein entsprechender Kabelsatz verbindet die Diagnosebaugruppe 72 mit der Lüfterplatine und mit dem Schottsystem 23, insbesondere mit dem Schiebegitter mit Hubmagnet 233 und mit dessen Endlagenkontrolle 231, 232.

In **Fig. 2** ist ein Schaltplan für den zweiten Erfassungspfad 7 mit zweiter Detektionsvorrichtung 4 und Kühlsystem gemäß einer Ausführungsform der vorliegenden Erfindung dargestellt.

Die zweite Detektionsvorrichtung 4 weist in der dargestellten Ausführungsform einen Rauchmelder sowie ein Überwachungssystem zur Überwachung der Funktionsfähigkeit der zweiten Detektionsvorrichtung 4 auf, das bei Detektion eines Störzustands der zweiten Detektionsvorrichtung 4 ein Störungssignal erzeugt. Die Signalisierung des Störzustands umfasst beispielsweise die Signalisierung eines Lebenszeichen-Signals und/oder die Signalisierung einer Verschmutzung des Rauchmelders.

Bevorzugt weist die zweite Detektionsvorrichtung 4 ein erstes Überwachungsausgaberelais 42 zur Signalisierung eines Lebenszeichen-Signals der zweiten Detektionsvorrichtung 4 auf. Des weiteren weist die zweite Detektionsvorrichtung 4 ein Ausgaberelais 43 zur Signalisierung einer Rauchentwicklung durch den Rauchmelder auf. Ein zweites Überwachungsausgaberelais 44 der zweiten Detektionsvorrichtung 4 dient der Signalisierung einer Verschmutzung des Rauchmelders. Die zweite Detektionsvorrichtung 4 weist weiterhin eine Steuerstromversorgung 41 mit einem Steuerspannungsmonitor von 24VDC auf.

Die Erfassung eines Fehlerfalls, d.h. eines Brandfalls und/oder einer Störfalls der zweiten Detektionsvorrichtung 4, beispielsweise ein Verschmutzung des Rauchmelders oder eine Funktionsstörung der zweiten Detektionsvorrichtung 4, erfolgt im zweiten Erfassungspfad 7 low-aktiv. Das heisst, im Normalbetrieb ist das Überwachungsausgaberelais 42 für das Lebenszeichensignal der zweiten Detektionsvorrichtung 4 eingeschaltet, das Ausgaberelais 43 für die Signalisierung von Rauch ausgeschaltet und das Überwachungsausgaberelais 44 für die Signalisierung einer Verschmutzung des Rauchmelders ist ebenfalls ausgeschaltet.

Die zweite Detektionsvorrichtung 4 ist mit der Diagnosebaugruppe 72 verbunden. Die Diagnosebaugruppe 72 weist bevorzugt eine Auswerteschaltung zur Verknüpfung der am ersten und zweiten Eingang der Diagnosebaugruppe 72 eingehenden Signale auf, wobei die Auswerteschaltung derart ausgestaltet ist, dass bei Signalisierung einer Rauchentwicklung am ersten Eingang und/oder bei Signalisierung eines Störzustands am zweiten Eingang ein Fehlerfall am zweiten Eingang der Steuereinheit signalisiert wird. Die Auswerteschaltung weist eine Erfassungsschaltung 727, eine Logikschaltung 728 und einen Schaltverstärker 729 auf.

Die über die Überwachungsausgaberelais 42, 44 und das Ausgaberelais 43 von der zweiten Detektionsvorrichtung 4 abgegebenen Signale werden über die Eingänge 727.4, 727. 5, 727. 6 der Erfassungsschaltung 727 zugeführt. Über die Eingangsdioden und die Testeingangsschalter 727.1, 727.2 und 727.3 gelangt das jeweilige Signal über die zugeordneten Filter- und Begrenzerschaltungen 727.7 auf die Eingänge der Logikschaltung 728.

In der Logikschaltung 728 erfolgt die eigentlich inhaltliche Verarbeitung der Signale, nämlich deren logische Verknüpfung. Die Logikschaltung 728 weist ein UND-Gatter 728.1 und eine Selbsttesterkennung 728.7 sowie ein NAND-Gatter 728.2 auf, dessen Eingänge mit den Ausgängen des UND-Gatters 728.1 und der Selbsttesterkennung 728.7 verbunden sind. Die Eingänge des UND-Gatters 728.1 sind mit dem Steuerspannungsmonitor 41, sowie mit den Ausgängen der Erfassungsschaltung 727 verbunden.

Bevorzugt führt die zweite Detektionsvorrichtung 4 im Einschaltmoment mittels der Selbsttesterkennung 728.7 für die Zeit tₛ einen Selbstest durch. Die Schaltungsanordnung wird mittels des Ein-Schalters S3 eingeschaltet und mit der Betriebsspannung U_{B24V} versorgt. Das Schalten der Ausgangskontakte der Überwachungsausgaberelais 42, 44 und dem Ausgaberelais 43 wird durch Aufleuchten der Leuchtdioden H7, H8, H9 zur Statusanzeige der zweiten Detektionsvorrichtung 4 signalisiert. Im Normalsbetrieb ist nach der Zeit tₛ das Überwachungsausgangsrelais 42 zur Signalisierung eines Lebenszeichen-Signals eingeschaltet, das Ausgangsrelais 43 zur Signalisierung einer Rauchentwicklung und das Überwachungsausgaberelais 44 Verschmutzung ausgeschaltet. Somit liegt H-Pegel an den Eingängen 727.4, 727.5, 727.6 der Erfassungsschaltung 727 an. Über die Eingangsdioden und die durchgesteuerten Testeingangsschalter 727.1, 727.2 und 727.3 gelangt der jeweilige H-Pegel über die zugeordneten Filter- und Begrenzerschaltungen 727.7 auf die Eingänge des UND-Gatters 728.1 und auf die Eingänge einer Selbsttesterkennung 728.7. Bei fehlerfreiem Betrieb liegt ein H-Pegel am Ausgang des UND-Gatters 728.1 an. Bei erfolgreichem Selbsttest liegt am Ausgang der Selbsttesterkennung 728.7 nach Ablauf der Zeit tₛ+tₛ₊ ebenfalls H-Pegel an. Am Ausgang des NAND-Gatters 728.2 liegt somit L-Pegel an.

Die Logikschaltung 728 weist weiterhin drei NAND-Gatter 728.3, 728.4 und 728.5 auf, die mit den Ausgängen der Erfassungsschaltung 727 verbunden sind. Bei Normalbetrieb liegt folglich H-Pegel an den Eingängen der NAND-Gatter 728.3, 728.4 und 728.5 an, so dass am Ausgang der NAND-Gatter 728.3, 728.4 und 728.5 L-Pegel anliegt.

Die Diagnosebaugruppe weist ein remanentes Speicherelement 723 zur Speicherung des Fehlerfalls auf. Das remanente Speicherelement 723 weist bevorzugt ein Remanenzrelais, besonders bevorzugt ein bistabiles Relais K2 mit Triebsystem 723.1 und Kontaktsystem 723.2 auf. Das remanente Speicherelement 723 weist ferner einen Rücksetztaster S2 zum Rücksetzen des bistabilen Relais auf. Hierdurch wird ein angezeigter Fehlerfall quittiert. In der vorliegenden Ausgestaltung weist das remanente Speicherelement 723 eine Fernsteuerung 723.3 für den Rücksetztaster S2 auf. Die Diagnosebaugruppe 72 weist hierzu bevorzugt eine Schnittstellenschaltung 728 mit Schnittstellenadapter 728.1 zur Fernsteuerung des Rücksetztasters S2 auf.

Die Diagnosebaugruppe 72 weist bevorzugt einen zwischen Logikschaltung 728 und remanentem Speicherelement 723 angeordneten Schaltverstärker 729 auf.

Der Ausgang des NAND-Gatters 728.2 ist über einen Schaltverstärker 729 mit dem Eingang des Setzeingang des bistabilen Relais K2 verbunden.

Im Normalbetrieb liegt L-Pegel am Ausgang des NAND-Gatters 728.2 an und es erfolgt keine Ansteuerung des Setzeingangs des Remanenzrelais K2 über den Schaltverstärker 729.

Die Diagnosebaugruppe 72 weist weiterhin ein Ausgabeelement 724 auf. Das Ausgabeelement 724 weist ein Ausgaberelais K1 auf. Das Ausgaberelais K1 ist bevorzugt ein monostabiles Relais. Die Ausgabe der Signale erfolgt über das Kontaktsystem 724.1 des Ausgaberelais K1. Das Triebsystem 724.2 des Ausgaberelais K1 ist mit dem Kontaktsystem 723.2 des Remanenzrelais K2 verbunden. Das Ausgabeelement 724 weist bevorzugt eine Schnittstelle X2 zum Auslesen des Ausgabesignals durch einen externen Rechner 12 auf.

Erfolgt, im Normalbetrieb, keine Ansteuerung des Setzeinganges des Remanenzrelais K2, wird K1 eingeschaltet und H-Pegel gelangt an den zweiten Eingang 512 der Steuereinheit 51. Mit den Signalen der Temperaturfühler 31, 32 führt dies im Normalbetrieb zu einer GUT-Meldung, die in der zentralen Recheneinheit 52 des zentralen Steuerrechners 5 verarbeitet wird. Über BUS-Treiber 53 und BUS-Koppler 8 erfolgt die Ankopplung an das BUS-System, insbesondere das BUS-System des Schienenfahrzeugs. Die weitere Signalisierung erfolgt über das BUS-System. Die Kühlsystemsteuerung 24 weist beispielsweise eine Antibetauungsschaltung 241 auf. Gibt die Antibetauungsschaltung 241 frei, laufen die Lüfter 21, 22 an, die Leuchtdioden H1, H2 zur Statusanzeige des ersten und zweiten Lüfters 21, 22 leuchten auf. Das Schottsystem 23 öffnet und die Leuchtdioden H4 und H6 zur Statusanzeige des Schottsystems 23 schalten ein.

Die Diagnosebaugruppe 72 weist eine Testschaltung zur Überprüfung der zweiten Detektionvorrichtung 4 auf. Die Testschaltung wird über eine Ansteuerung mittels der Testtaster 722.4.2 bis 722.4.4 manuell über den Testschalter S1 oder mittels einer Fernsteuerung 722.4 angesteuert. Die Fernsteuerung 722.4 erfolgt über die Schnittstellenschaltung 728. Die Testmöglichkeiten sind diversitär ausgeführt. Es kann sowohl ein Gesamttest mittels des Testtasters 722.4.1 für alle der Eingänge der Rauchmeldersignale ausgeführt werden als auch eine Einzelansteuerung der Eingänge der Rauchmeldersignale über die Testtaster 722.4.2 bis 722.4.4. Die Testtaster 722.4.2 bis 722.4.4 bzw. 722.4.1 steuern die Testschalter 727.1, 727.2, 727.3 , so dass eine Unterbrechung des jeweiligen Signalpfads bei Einzelansteuerung oder gleichzeitiger Ansteuerung aller Testschalter 727.1, 727.2, 727.3 entsteht, die dann zum Setzen des Remanenzrelais K2 führt. Für den Test der ersten Detektionsvorrichtung 3, insbesondere des ersten und zweiten Temperaturfühlers 31, 32, ist eine schaltbare Unterbrechung 54 im ersten Erfassungspfad 6 zwischen erster Detektionsvorrichtung 3 und Steuereinheit 51 vorgesehen.

Die Diagnosebaugruppe 72 weist weiterhin eine Anzeigevorrichtung 722 mit einer Anzeige 722.1 zur Anzeige der Betriebszustände der Lüfter auf, die über eine Auswertung der Tachosignale der Lüfter durch die Anzeige 722.1 bestimmt wird. Die Anzeigevorrichtung 722 weist weiterhin eine Anzeige 722.2 zur Anzeige der Statuszustände des Schottsystems auf. Die Statuszustände umfassen die Anzeige zum Öffnungszustand des Schiebegitters 'Schiebegitter zu', 'Schiebegitter auf', der Versorgungsspannung und zum Betriebszustand des Hubmagneten 'Magnet ein'. Die Anzeigevorrichtung 722 weist weiterhin eine Anzeige 722.3 zur Anzeige von Fehlermeldungen auf. Die Taster S1 und S2 sind bevorzugt in der Anzeigevorrichtung 722 angeordnet. Für die Grundeinstellung des Luftvolumenstroms ist ein DIP-Schalter 243.7 zur Ansteuerung der PWM 243 auf der Anzeigevorrichtung vorgesehen. Mittels der Schalter 243.4 bis 243.6 lassen sich die Widerstände 243.1 bis 243.3 aktivieren und so der Luftstrom einstellen.

Im Fehlerfall liegt L-Pegel an einem der Überwachungsausgaberelais 42, 44 und/oder dem Ausgaberelais 43 an. Dies wird über die Erfassungsschaltung 727 auf die Eingänge des UND-Gatters 728.1 gegeben. Am Ausgang des UND-Gatters 728.1 liegt somit L-Pegel an. Bei erfolgreichem Selbsttest liegt H-Pegel am Ausgang der Selbsttesterkennung 728.7 an. Am Ausgang des NAND-Gatters 729 liegt somit H-Pegel an. Dieser wird über den Schaltverstärker 729 auf den Setzeingang des Remanenzrelais K2 gegeben. Das Triebsystem 723.1 schaltet. Über das Ausgaberelais K1 wird L-Pegel an den Eingang der Steuereinheit 51 gegeben. Eine Abschottung des Schaltschranks 1 und/oder ein Ausschalten der Lüfter 21, 22 wird über den zentralen Steuerrechner 5 und das BUS-System durch die Kühlsystemsteuerung, insbesondere die Schottsystemsteuerung 6.2 ausgelöst.

Das Schottsystem 23 weist einen Hubmagnet 231 auf. Die Stellung des Hubmagneten 231 und damit die Stellung des von dem Hubmagneten 231 angesteuerten Schiebegitters werden über die Endlagenschalter 232, entsprechend dem offenen Schiebegitter und Endlagenschalter 233, entsprechend dem geschlossenen Schiebegitter an die Anzeigenvorrichtung 722, insbesondere die Anzeige 722.2 zur Anzeige der Statuszustände des Schottsystems signalisiert. Auch eine Signalisierung der Stromerkennung 234 Triebsystemspule des Hubmagneten 231 erfolgt in der Anzeige 722.2 zur Anzeige der Statuszustände des Schottsystems.

Mit dem System gemäß der dargestellten Ausgestaltung wird ein extrem sicheres und zuverlässiges System mit einem offenen Schaltschrank, Kühlsystem und einer Schaltungsanordnung zur sicherheitsgerichteten Steuerung des Kühlsystems zur Verfügung gestellt. Die Eintretenswahrscheinlichkeit für ein unerkanntes kritisches Ereignis, beispielsweise Brand, Rauch und/oder Übertemperatur, beträgt für eine Flotte von 1000 Betrachtungseinheiten mehr als 150 Jahre. Dies ergibt sich aus einer entsprechenden Zuverlässigkeitsberechnung, beispielsweise mittels iFMECA (integrated Failure Mode, Effects and Criticality Analysis).

### BEZUGSZEICHENLISTE

- 1: offener Schaltschrank
- 2: Kühlsystem
- 21: erster Lüfter
- 22: zweiter Lüfter
- 211: erster Spannungswandler
- 212: zweiter Spannungswandler
- 23: Schottsystem
- 231: Endlagenschalter ,Schiebegitter zu'
- 232: Endlagenschalter ,Schiebegitter auf'
- 233: Hubmagnet 24 VDC/ 25W
- 234: Stromerkennung der Triebsystemspule des Hubmagneten
- 24: Kühlsystemsteuerung
- 241: Antibetauungsschaltung
- 242: Schottsystemsteuerung
- 243: Pulsweitenmodulation
- 243.1 bis 243.3: Widerstände
- 243.4 bis 243.6: Schalter
- 243.7: DIP-Schalter
- 244.1 bis 244.2: Temperaturfühler der temperaturgesteuerten Kühlsystemsteuerung
- 3: erste Detektionsvorrichtung
- 31: erster Temperaturfühler
- 311: erster Temperatursensor
- 312: erstes Ausgaberelais des ersten Temperaturfühlers
- 32: zweiter Temperaturfühler
- 321: zweiter Temperatursensor
- 322: zweites Ausgaberelais des zweiten Temperaturfühlers
- 4: zweite Detektionsvorrichtung
- 41: Steuerstromversorgung
- 42: erstes Überwachungsausgaberelais der zweiten Detektionsvorrichtung (Lebenszeichen/Störung)
- 43: Ausgaberelais der zweiten Detektionsvorrichtung (Rauch)
- 44: zweites Überwachungsausgaberelais der zweiten Detektionsvorrichtung (Verschmutzung)
- 5: zentraler Steuerrechner (HSDR)
- 51: Steuereinheit
- 511: erster Eingang der Steuereinheit
- 512: zweiter Eingang der Steuereinheit
- 52: zentrale Recheneinheit (CPU)
- 53: BUS-Treiber
- 54: schaltbare Unterbrechung (für Testzwecke)
- 6: erster Erfassungspfad
- 7: zweiter Erfassungspfad
- 71: Verbundkabel
- 72: Diagnosebaugruppe
- 721: Zusatzbaugruppe
- 721.1: Dioden-UND-Matrix
- 721.2: monostabiles Relais der Zusatzbaugruppe
- 722: Anzeigevorrichtung
- 722.2: Anzeige der Statuszustände des Schottsystems
- 722.3: Anzeige von Fehlermeldungen
- 722.4: Fernsteuerung
- 722.4.1 bis 722.4.4: Testtaster zur Ansteuerung der Testeingangsschalter
- 723: remanentes Speicherelement
- 723.1: Triebsystem des Remanenzrelais
- 723.2: Kontaktsystem des Remanenzrelais
- 723.3: Fernsteuerung für Rücksetztaster S2
- 724: Ausgabeeinheit
- 724.1: Ausgang; Kontaktsystem des Ausgaberelais
- 724.2: Triebsystem des Ausgaberelais
- 727: Erfassungsschaltung
- 727.1 bis 727.3: Testeingangsschalter
- 727.4 bis 727.6: Eingänge der Erfassungsschaltung
- 727.7: Filter- und Begrenzerschaltung
- 728: Logikschaltung
- 728.1: UND-Gatter
- 728.2: NAND-Gatter
- 728.3 bis 728.5: NAND-Gatter
- 728.7: Selbsttesterkennung
- 729: Schaltverstärker
- 73: Verbindungskabel
- 8: BUS-Koppler
- 9: angepasster BUS-Koppler für die Verbindung 73
- 10: Steuerstromversorgung
- 11: 14V-Summenpunkt
- 12: Externer Rechner
- X2: Schnittstelle Fernbedienung Testschaltung
- X3: CAN-Schnittstelle
- S1: Testtaster
- S2: Rücksetztaster
- S3: Ein-Schalter
- K1: Ausgaberelais
- K2: Remanenzrelais
- PTC: Sicherungselement für 24VDC
- Rₚ: Widerstandskombination
- Q: Luftvolumenstrom
- ϑa: Temperatur

## Patentansprüche

1. System, insbesondere für ein Schienenfahrzeug, mit
einem offenen Schaltschrank (1), der eine Öffnung zur Kühlung aufweist,
einem Kühlsystem (2) und
einer Schaltungsanordnung zur sicherheitsgerichteten Steuerung des Kühlsystems (2), die eine erste Detektionsvorrichtung (3) zur Detektion eines Brands im Schaltschrank (1) und eine Steuereinheit (51) aufweist, wobei ein Ausgang der Steuereinheit (51) mit dem Kühlsystem (2) verbunden ist,
wobei die Schaltungsanordnung einen ersten Erfassungspfad (6) zur Signalisierung eines Fehlerfalls an die Steuereinheit (51) aufweist, der einen Ausgang der ersten Detektionsvorrichtung (3) mit einem ersten Eingang (511) der Steuereinheit (51) verbindet,
**dadurch gekennzeichnet, dass** die Schaltungsanordnung eine zweite Detektionsvorrichtung (4) zur Detektion eines Brands im Schaltschrank (1) aufweist, wobei die Schaltungsanordnung einen zweiten Erfassungspfad (7) zur Signalisierung eines Fehlerfalls an die Steuereinheit (51) aufweist, der mindestens einen Ausgang (42, 43, 44) der zweiten Detektionsvorrichtung (4) mit einem zweiten Eingang (512) der Steuereinheit (51) verbindet, wobei die Steuereinheit (51) derart ausgestaltet ist, dass bei Signalisierung eines Fehlerfalls am ersten Eingang (511) der Steuereinheit (51) und/oder bei Signalisierung eines Fehlerfalls am zweiten Eingang (512) der Steuereinheit (51) am Ausgang der Steuereinheit (51) ein Alarm signalisiert wird.

2. System nach Anspruch 1, **dadurch gekennzeichnet, dass** das Kühlsystem (2) mindestens einen der Öffnung des Schaltschranks (1) zugeordneten Lüfter (21, 22), ein Schottsystem (23) zur Abschottung des Schaltschranks (1) und eine Kühlsystemsteuerung (24) zur Steuerung des mindestens einen Lüfters (21, 22) und des Schottsystems (23) aufweist.

3. System nach einem der Ansprüche 1 bis 2, **dadurch gekennzeichnet, dass** die Steuereinheit (51) in einem zentralen Steuerrechner (5) eines Schienenfahrzeugs angeordnet ist.

4. System nach einem der Ansprüche 1 bis 3, **dadurch gekennzeichnet, dass** die Signalisierung des Fehlerfalls im ersten und im zweiten Erfassungspfad (6, 7) low-aktiv erfolgt.

5. System nach einem der Ansprüche 1 bis 4, **dadurch gekennzeichnet, dass** die erste Detektionsvorrichtung (3) mindestens einen Temperaturfühler (31, 32) aufweist.

6. System nach einem der Ansprüche 1 bis 5, **dadurch gekennzeichnet, dass** die zweite Detektionsvorrichtung (4) einen Rauchmelder aufweist und der mindestens eine Ausgang der zweiten Detektionsvorrichtung (4) ein Ausgang (43) zur Signalisierung einer Rauchentwicklung durch den Rauchmelder ist.

7. System nach Anspruch 6, **dadurch gekennzeichnet, dass** die zweite Detektionsvorrichtung (4) eine Überwachungseinheit zur Überwachung der Funktionsfähigkeit der zweiten Detektionsvorrichtung (4) und mindestens einen Überwachungsausgang zur Signalisierung eines Störzustands (42, 44) der zweiten Detektionsvorrichtung (4) aufweist, wobei der mindestens eine Überwachungsausgang zur Signalisierung des Störzustands (42, 44) über den zweiten Erfassungspfad (7) mit dem zweiten Eingang (512) der Steuereinheit (51) verbunden ist.

8. System nach Anspruch 7, **dadurch gekennzeichnet, dass** der zweite Erfassungspfad (7) zwischen der zweiten Detektionsvorrichtung (4) und der Steuereinheit (51) eine Diagnosebaugruppe (72) zur Verarbeitung von Ausgangssignalen der zweiten Detektionsvorrichtung (4) aufweist, wobei der mindestens eine Ausgang (43) zur Signalisierung einer Rauchentwicklung mit einem ersten Eingang (727.5) der Diagnosebaugruppe (72) verbunden ist und der mindestens eine Überwachungsausgang (42, 44) zur Signalisierung eines Störzustands der zweiten Detektionsvorrichtung (4) mit einem zweiten Eingang (727.4, 727.6) der Diagnosebaugruppe (72) verbunden ist und ein Ausgang (724.1) der Diagnosebaugruppe (72) mit dem zweiten Eingang (512) der Steuereinheit (51) verbunden ist.

9. System nach Anspruch 8, **dadurch gekennzeichnet, dass** die Diagnosebaugruppe (72) über einen zweiten Ansteuerpfad (73) mit der Kühlsystemsteuerung (24) verbunden ist.

10. System nach einem der Ansprüche 8 bis 9, **dadurch gekennzeichnet, dass** die Diagnosebaugruppe (72) eine Zusatzbaugruppe (723) zur Überwachung von Kurzschluss und/oder Unterbrechungen aufweist.

11. System nach einem der Ansprüche 8 bis 10, **dadurch gekennzeichnet, dass** die Diagnosebaugruppe (72) eine Auswerteschaltung zur Verknüpfung der am ersten und zweiten Eingang (727.4, 727.5, 727.6) der Diagnosebaugruppe (72) eingehenden Signale aufweist, wobei die Auswerteschaltung derart ausgestaltet ist, dass bei Signalisierung einer Rauchentwicklung am ersten Eingang (727.5) und/oder bei Signalisierung eines Störzustands am zweiten Eingang (727.4, 727.6) ein Fehlerfall am zweiten Eingang (512) der Steuereinheit (51) signalisiert wird.

12. System nach einem der Ansprüche 8 bis 11, **dadurch gekennzeichnet, dass** die Diagnosebaugruppe (72) ein remanentes Speicherelement 723 zur Speicherung des Fehlerfalls aufweist.

13. System nach einem der Ansprüche 8 bis 12, **dadurch gekennzeichnet, dass** die Diagnosebaugruppe (72) eine Testschaltung zur Überprüfung der zweiten Detektionsvorrichtung (4) und der Diagnosebaugruppe (72) aufweist, wobei bei Auslösen der Testschaltung die Signalisierung einer Rauchentwicklung und/oder die Signalisierung eines Störzustands simuliert werden.

14. System nach einem der Ansprüche 8 bis 13, **dadurch gekennzeichnet, dass** die Diagnosebaugruppe (72) eine Schnittstelle (X3) zur Verbindung mit einem externen Rechner (12) zur Ansteuerung der Testschaltung aufweist.

15. System nach einem der Ansprüche 2 bis 14, **dadurch gekennzeichnet, dass** die Kühlsystemsteuerung (24) eine Antibetauungsschaltung (241) aufweist, die den mindestens einen Lüfter (21, 22) und das Schottsystem (23) so schaltet, dass Betauungszustände im Schaltschrank vermieden werden.
